# EUROPEAN PATENT SPECIFICATION

(11) **EP 0 967 260 B1**
(45) Date of publication and mention of the grant of the patent: **11.05.2005**
(21) Application number: 99304842.0
(22) Date of filing: 21.06.1999
(51) Int. Cl.: C09G 1/02

(54) **Method of polishing a silicon wafer using a polishing composition and a surface treating composition**
Polierverfahren für Silizium-Wafer unter Verwendung einer Polierzusammensetzung und einer Oberflächenbehandlungszusammensetzung
Procédé de polissage d'une plaquette de silicium utilisant une composition de polissage et une composition pour le traitement de surface

(30) Priority: 22.06.1998 JP 17465698; 23.04.1999 JP 11684899; 16.06.1999 JP 16942899
(43) Date of publication of application: 29.12.1999
(73) Proprietor: FUJIMI INCORPORATED, Nishikasugai-gun Aichi-ken (JP)
(72) Inventor: Inoue, Yutaka, c/o Fujimi Incorporated, Nishikasugai-gun, Aichi (JP); Ito, Masatoki, c/o Fujimi Incorporated, Nishikasugai-gun, Aichi (JP)
(74) Representative: Paget, Hugh Charles Edward

(56) References cited:
- EP-A- 0 373 501
- EP-A- 0 773 270
- EP-A- 0 846 741
- US-A- 4 057 939

## Description

The present invention relates to a surface treating method and a polishing method suitable for surface treatment of semiconductor wafers. More particularly, the present invention relates to use of a surface treating composition or a polishing composition which has a high polishing removal rate and is capable of forming an extremely smooth surface by reducing formation of waviness in specular finish of low resistance silicon wafers containing a large amount of a dopant in the wafers and having a resistivity of at most 0.1 Ω·cm.

In recent years, high performance semiconductor device chips to be used for high technology products including computers, have been developed for high integration and large capacity, and enlargement of the chip size due to the large capacity is now in progress. The demand for epitaxial wafers to be used for discrete semiconductors, bipolar IC, MOSIC and other high performance semiconductor devices, is increasing year after year. And, miniaturization in the design rule for semiconductor devices has been advanced year after year, whereby the focal depth in the process for producing devices has been shallow, and the precision of the finished surface required for wafers before forming into devices, has been increasingly strict.

As parameters for the precision of the finished surface, various surface defects such as LPD, deposition of relatively large foreign matters, scratches, the surface roughness, the haze level and SSS (Sub-Surface Scratches, a type of fine scratches which are also called latent scratches), may, for example, be mentioned.

LPD includes one attributable to fine foreign matters (hereinafter referred to as "particles") deposited on the wafer surface, and one attributable to COP (Crystal Originated Particles). The relatively large foreign matters deposited on wafers include a dried gel formed by drying of the polishing composition and those attributable to other causes.

If such LPD or relatively large foreign matters are present, pattern defects, break down voltage of insulators, failure in ion injection and deterioration of other device properties, are likely to be brought about, and the yield is likely to be low. Accordingly, wafers having such surface defects reduced, or a process for producing such wafers, is now being studied.

Silicon wafers which are typical semiconductor substrates, are prepared by slicing a silicon single crystal ingot to obtain wafers, which are then subjected to rough polishing called lapping, for contour shaping. Then, a damaged layer formed on the wafer surface during the slicing or lapping step, is removed by etching, followed by polishing the wafer surface to a specular surface to obtain silicon wafers. This polishing usually comprises a plurality of polishing steps, specifically a stock removal polishing, a secondary polishing and a finish polishing (final polishing). Depending upon the process, the secondary polishing may be omitted, or a further polishing step may be added between the secondary polishing and the final polishing.

The above silicon single crystal ingot is one having a single crystal of silicon grown by CZ method or FZ method. FZ method has merits such that contamination by impurities is little, and a single crystal having a high resistivity can be grown, but it also has drawbacks such that it is difficult to enlarge the diameter or to control the resistivity, and it has a peculiarity as a method for producing a single crystal. Accordingly, CZ method is mainly used at present. According to CZ method, a single crystal is grown in such a manner that growth of the single crystal is initiated by seed crystals having a predetermined orientation, at a center portion of the surface of a melt of silicon heated and melted in a quartz crucible in a sealed container having a reduced pressure argon gas atmosphere, and the single crystal is withdrawn as an ingot having a desired shape.

It is usually possible to lower the resistivity of wafers, by incorporating antimony, arsenic, boron or other dopants in a larger amount than usual, into the above silicon melt. A wafer having a resistivity of at most 0.1 Ω·cm, is commonly called as a low resistance wafer. The above mentioned epitaxial wafer is one having a thin film of a silicon single crystal (hereinafter referred to as "an epitaxial layer") free from crystal defects, grown on the surface of such a low resistance wafer, by a chemical or physical means.

When the silicon single crystal is withdrawn in CZ method, the dopant substance in the silicon melt is likely to be relatively easily taken into the single crystal, and as the withdrawing advances, the dopant concentration in the silicon melt decreases. Therefore, for the purpose of making the dopant concentration in the ingot constant, a suitable amount of a silicon melt or a dopant is supplemented to the quartz crucible during the withdrawing, but it is difficult to make the dopant concentration in the withdrawn ingot to be uniform. If an ingot obtained from the melt containing a dopant by such a method, is sliced, nonuniformity in the dopant concentration is likely to appear concentrically.

Heretofore, for polishing a usual low resistance wafer, it has been common to employ a polishing composition comprising water, silicon dioxide and a polishing accelerator such as an amine or ammonia. If this polishing composition is used for polishing a low resistance wafer having a high dopant concentration, concentric waviness (hereinafter referred to as "dopant striation") corresponding to the nonuniformity in the dopant concentration may form on the wafer surface. Formation of such dopant striation is remarkable in the stock removal polishing where the polishing removal rate is high. In the secondary polishing or the final polishing which is carried out after the stock removal polishing, the polishing removal rate is usually low as compared with the stock removal polishing, and it is difficult to mend the waviness formed in the stock removal polishing by the secondary or subsequent polishing operation. Even if the amount of the polishing accelerator used in the stock removal polishing is reduced for the purpose of reducing formation of such dopant striation, the effects for reducing the dopant striation is small, and another problem that the polishing removal rate lowers substantially, is likely to result. In the actual polishing process, the polishing composition may be used repeatedly by recycling, and if the composition may be repeatedly used by recycling in a state where the amount of an additive is reduced, there has been a problem that the polishing removal rate decreases substantially.

On the other hand, the second and subsequent polishing operation, particularly the final polishing, is intended to smooth the wafer surface polished in the preceding step. Namely, in the second and subsequent polishing operation, it is important to be able to reduce the surface roughness and to prevent formation of microprotrusions, micropits and other fine surface defects, rather than to have a large ability to mend waviness or relatively large surface defects as required in the stock removal polishing. Further, from the viewpoint of productivity, it is important that the polishing removal rate is high. As far as the present inventors are aware, in the conventional two step polishing, it has been possible to obtain a wafer surface having small surface roughness in the secondary polishing, but the polishing removal rate used to be very low and inadequate for practical production, and it has been difficult to prevent formation of microprotrusions, micropits and other surface defects.

US-A-4 057 939 discloses the polishing of silicon wafers with an aqueous composition of abrasive particles, a soluble alkali metal base and sodium and potassium salts of dihalo isocyanuric acid as oxidizing agent.

EP-A-0 373 501 discloses a polishing compound for polishing silicon wafers which comprises water, silica particles, a water-soluble polymeric compound and a water-soluble salt.

Accordingly, it has been desired to use a polishing composition or a surface treating composition which has a high polishing removal rate and which is capable of forming a very smooth polished surface without formation of dopant striation, in the polishing operation of low resistance wafers having a resistivity of at most 0.1 Ω · cm.

The present invention has been made to solve the above problems, and it is an object of the present invention to provide a method using a polishing composition which has a high polishing removal rate and which is capable of forming a very smooth polished surface without forming dopant striation, in polishing of low resistance wafers having a resistivity of at most 0.1 Ω·cm, especially wafers prepared by CZ method. It is a further object of the present invention to provide a surface treating method using a composition which acts on the surface of the object to be treated before polishing, to reduce formation of dopant striation in the polishing and which is effective for cleaning the surface of the polished object.

The present invention provides a method of polishing a silicon wafer having a resistivity of at most 0.1 Ω·cm, as set out in claim 1.

Further, the present invention provides a method of surface treating a silicon wafer having a resistivity of at most 0.1 Ω·cm, as set out in claim 9.

The polishing composition used in the present invention is capable of forming a very smooth polished surface having no waviness in the polishing operation of low resistance silicon wafers having a resistivity of at most 0.1 Ω · cm, particularly those prepared by CZ method, and has a high polishing removal rate, and when it is used by recycling, decrease in the polishing removal rate is small.

The surface treating composition used in the present invention is employed before or after the polishing operation of low resistance silicon wafers having a resistivity of at most 0.1 Ω·cm, whereby formation of waviness in the polishing treatment can be reduced, or the effect for surface cleaning after the polishing will be high.

Now, the present invention will be described in detail with reference to the preferred embodiments.

### Additive

The surface treating composition or the polishing composition used in the present invention comprises water and an additive. This additive accelerates the polishing action by a chemical action as a polishing accelerator in the polishing composition, and in the surface treating composition containing no abrasive, it provides an action for surface treatment prior to the polishing or an action to rinse the surface after the polishing.

As such an additive, the following may be used.
(a) An alkali metal hydroxide such as potassium hydroxide or sodium hydroxide,
(b) An alkali metal carbonate such as potassium carbonate or sodium carbonate,
(c) An alkali metal hydrogencarbonate such as potassium hydrogencarbonate or sodium hydrogencarbonate,
(d) A quaternary ammonium salt such as tetramethylammonium hydroxide, tetraethylammonium hydroxide or tetrabutylammonium hydroxide,
(e) A peroxide such as hydrogen peroxide, sodium peroxide, potassium peroxide, lithium peroxide, calcium peroxide or zirconium peroxide, and
(f) A peroxo acid salt such as peroxodisulfuric acid, ammonium peroxodisulfate, potassium peroxodisulfate, sodium peroxodisulfate, peroxodiphosphoric acid, potassium peroxodiphosphate, potassium peroxocarbonate, sodium peroxoborate, magnesium peroxoborate or potassium peroxoborate.

Such an additive is required to be dissolved in the composition. These additives may be used in combination in optional proportions within a range not impair the effects of the present invention. The content of such an additive in the composition used in the present invention, varies depending upon the type of the compound used or the purpose of the composition, but it is usually from 0.001 to 50 wt%, based on the total weight of the composition.

When the composition used in the present invention is used for stock removal polishing, the concentration of the additive is preferably set at a relatively high level. Especially when the additive is an alkali metal hydroxide, carbonate or hydrogencarbonate, it is preferably from 0.001 to 30 wt%, more preferably from 0.01 to 5 wt%, most preferably from 0.05 to 3 wt%. When the additive is a quaternary ammonium salt, it is preferably from 0.05 to 15 wt%, more preferably from 0.1 to 10 wt%, most preferably from 0.5 to 5 wt%. When the additive is a peroxide, it is preferably from 0.01 to 50 wt%, more preferably from 0.1 to 30 wt%, most preferably from 0.5 to 25 wt%. When the additive is a peroxo acid salt, it is preferably from 0.01 to 50 wt%, more preferably from 0.1 to 30 wt%, most preferably from 0.5 to 25 wt%.

On the other hand, when the composition is used for a second or subsequent polishing operation, especially for final polishing, the additive is preferably in a low concentration. Especially when the additive is an alkali metal hydroxide, carbonate or hydrogencarbonate, it is preferably from 0.001 to 30 wt%, more preferably from 0.01 to 5 wt%, most preferably from 0.05 to 3 wt%. When the additive is a quaternary ammonium salt, it is preferably from 0.005 to 15 wt%, more preferably from 0.01 to 10 wt%, most preferably from 0.05 to 5 wt%. When the additive is a peroxide, it is preferably from 0.001 to 50 wt%, more preferably from 0.01 to 30 wt%, most preferably from 0.05 to 25 wt%. When the additive is a peroxo acid salt, it is preferably from 0.001 to 50 wt%, more preferably from 0.01 to 30 wt%, most preferably from 0.05 to 25 wt%.

When such an additive is used for a polishing composition, there is a tendency that as the amount increases, the polishing removal rate becomes high, and when it is used repeatedly by recycling, decrease of the polishing removal rate becomes small. However, if the amount is excessively large, the chemical action as a polishing composition tends to be too strong, whereby a surface defect such as surface roughening of the wafer surface due to a strong etching action, is likely to result, or the dispersion stability of abrasive grains is likely to be lost, whereby precipitates may form. On the other hand, if the amount is too small, the polishing removal rate tends to be low, and it takes a long time for polishing operation, whereby the productivity decreases, such being not practical. Especially when fumed silica is used as the abrasive, gelation is likely to take place in the polishing composition, and the dispersion stability tends to be poor, and the viscosity of the composition tends to be so high that the handling will be difficult.

When a surface treating composition containing such an additive is used for rinsing treatment after the polishing treatment, removal of the residue on the surface or removal of the dried polishing composition will be facilitated.

### Water-soluble polymer

The composition used in the present invention may contain a water-soluble polymer. Especially when the composition is used for a second or subsequent polishing operation, particularly for final polishing, it is preferred that the composition contains a water-soluble polymer. The wafer surface immediately after polishing has hydrophobicity, and when the polishing composition, dust in air or other foreign matters are deposited on the wafer surface in such a state, the abrasive in the composition or the foreign matters will be dried and solidified to firmly fix on the wafer surface, thus causing deposition of particles on the wafer surface. Whereas, in the polishing composition used in the present invention, the water-soluble polymer has a function to provide hydrophilicity on the wafer surface so that the wafer surface will not dry up in a short period of time from the completion of the polishing to the subsequent step of cleaning. The water-soluble polymer to be used, is required to be dissolved in the composition. The water-soluble polymer to be used is not particularly limited so long as it does not impair the effects of the present invention. However, it is usually a polymer having hydrophilic groups and having a molecular weight of at least 100,000, preferably at least 1,000,000. Here, the hydrophilic groups may, for example, be hydroxyl groups, carboxyl groups, carboxylic acid ester groups, sulfonic groups and others. Specifically, such a water-soluble polymer is preferably at least one member selected from a cellulose derivative and polyvinyl alcohol. The cellulose derivative is preferably at least one member selected from the group consisting of carboxymethyl cellulose, hydroxyethyl cellulose, hydroxypropyl cellulose, methyl cellulose, ethyl cellulose, ethylhydroxyethyl cellulose and carboxymethylethyl cellulose. Particularly preferred is hydroxyethyl cellulose. These water-soluble polymers may be used in combination in an optional ratio.

The content of the water-soluble polymer in the polishing composition used in the present invention varies depending upon the type of the water-soluble polymer used or the types or contents of other components in the composition. However, it is usually preferably from 0.001 to 10 wt%, more preferably from 0.003 to 3 wt%, particularly preferably from 0.005 to 0.3 wt%, based on the total amount of the polishing composition. If the amount of the water-soluble polymer exceeds the above range substantially, the viscosity of the composition will be too high, and dischargeability of the waste liquid of the composition from the polishing pad tends to be poor. On the other hand, if the amount is too small, the hydrophilicity of the wafer after polishing tends to be poor, and particles are likely to deposit.

Further, the solubility of the water-soluble polymer in the composition varies depending upon the contents of other components. Accordingly, even if the amount of the water-soluble polymer is within the above range, it may happen that the polymer is not completely dissolved or the water-soluble component once dissolved may precipitate. Such a precipitate may agglomerate with e.g. abrasive particles, whereby the handling efficiency tends to deteriorate. Accordingly, due care is required.

### Abrasive

The polishing composition used in the present invention contains an abrasive in addition to the above additive. As the abrasive, an, optional one may be employed within a range not to impair the effects of the present invention. However, it is preferred to use silicon dioxide.

The polishing composition used in the present invention is considered to have a mechanical polishing action by the abrasive and a polishing or polishing assisting action by a chemical action of the additive.

The silicon dioxide includes many types which are different in the properties or in the processes for their production. Among them, silicon dioxide which is preferably used for the polishing composition of the present invention is, for example, colloidal silica, fumed silica or precipitated silica.

Among them, colloidal silica is produced usually by particle growth of ultra-fine colloidal silica obtained by ion exchange of sodium silicate, or by hydrolysis of an alkoxysilane with an acid or alkali. Colloidal silica produced by such a wet method, is usually obtained in the form of a slurry as dispersed in water in the state of primary particles or secondary particles. Such colloidal silica is commercially available, for example, under a tradename of SPHERICA Slurry from Catalysts & Chemicals Ind. Co., Ltd.

In the present invention, when colloidal silica is employed, one produced by the above mentioned method may usually be employed. However, in the polishing operation of a semiconductor substrate, metal impurities are undesirable in many cases, and it is preferred to employ highly pure colloidal silica. Such highly pure colloidal silica can be produced by heat decomposition of an organic silicon compound in a wet system and has a characteristic that metal impurities are extremely little, and it is relatively stable even in a neutral region.

Fumed silica is one produced by combustion of silicon tetrachloride and hydrogen. Such fumed silica produced by a gas phase method is in the form of secondary particles having a chain structure wherein a few or a few tens primary particles get together and has a characteristic that the content of metal impurities is relatively small. Such fumed silica is commercially available, for example, under a tradename of Aerosil from Nippon Aerosil Co., Ltd.

Precipitated silica is water-containing amorphous silicon dioxide produced by reacting sodium silicate with an acid. Such precipitated silica produced by a wet system is in the form of bulky particles having spherical primary particles agglomerated like grapes and has a characteristic that the specific surface area and the pore volume are relatively large. Such precipitated silica is commercially available, for example, under a tradename of Carplex from Shionogi & Co.

These silicon dioxides may be used in combination in an optional ratio, as the case requires.

The silicon dioxide serves to polish the surface to be polished by a mechanical action as abrasive grains. The average particles size of the silicon dioxide to be used for the polishing composition of the present invention is usually from 10 to 3,000 nm as an average secondary particle size obtained from the value measured by a light scattering method. Particularly, in the case of colloidal silica, the average particle size is preferably from 10 to 1,000 nm, more preferably from 15 to 500 nm, most preferably from 20 to 300 nm. In the case of fumed silica, it is preferably from 50 to 300 nm, more preferably from 100 to 300 nm, most preferably from 150 to 300 nm. Likewise, in the case of precipitated silica, it is preferably from 100 to 3,000 nm, more preferably from 200 to 2,500 nm, most preferably from 300 to 2,000 nm.

With the polishing composition used in the present invention, if the average particle size of silicon dioxide exceeds the above mentioned range, dispersion of abrasive grains tends to be hardly maintained, whereby there will be problems such that the stability of the composition deteriorates, abrasive grains tend to precipitate, scratches are likely to form at the polished wafer surface. On the other hand, if it is smaller than the above range, the polishing removal rate tends to be extremely low, and it will take a long time for processing, and the productivity tends to be too low to be practical.

The content of the abrasive in the polishing composition is usually from 0.01 to 50 wt%, preferably from 0.05 to 30 wt%, more preferably from 0.1 to 20 wt%, based on the total amount of the composition. If the content of the abrasive is too small, the polishing removal rate will be low, and it will take a long time for processing, whereby the productivity will be too low to be practical. On the other hand, if it is too large, uniform dispersion tends to be hardly maintained, and the viscosity of the composition tends to be excessive, whereby the handling tends to be difficult.

### Surface treating composition and polishing composition

The composition used in the present invention is prepared usually by mixing each of the above described components, i.e. the additive in the case of a surface treating composition, or the abrasive and the additive in the case of a polishing composition, in a desired content in water to disperse or dissolve it. The method for dispersing or dissolving these components in water is optional. For example, they may be dispersed by stirring by means of a vane type stirrer or by ultrasonic dispersion. Further, the mixing order of these components is optional. Namely, in the case of the polishing composition, either dispersion of the abrasive or dissolution of the additive may be carried out first, or both may be carried out simultaneously.

Further, at the, time of preparing the above described polishing composition, various known additives may further be incorporated, as the case requires, for the purpose of maintaining or stabilizing the quality of the product or depending upon the type of the object to be polished, the polishing condition and other necessities for polish processing. As such further additives, the following may be mentioned.
(a) Water-soluble alcohols, such as ethanol, propanol, and ethylene glycol.
(b) Surfactants such as sodium alkylbenzenesulfonate, and a condensate of naphthalenesulfonic acid with formalin.
(c) Organic polyanionic substances, such as a lignin sulfonate, and a polyacrylate.
(d) Chelating agents, such as dimethylglyoxime, dithizone, oxine, acetylacetone, glycine, EDTA, and NTA.
(g) Fungicides, such as sodium alginate, and potassium hydrogencarbonate.

Further, the above abrasive or additive which is suitable for use in the polishing composition used in the present invention, may be used as an auxiliary additive for a purpose other than the above mentioned purposes, for example, for preventing precipitation of the abrasive.

The polishing composition used in the present invention can be prepared, stored or transported in the form of a stock liquid having a relatively high concentration, and can be used as diluted at the time of actual polishing operation. The above-mentioned preferred range of concentration is one for the actual polishing operation, and if a method of diluting the composition at the time of actual use is adopted, needless to say, the composition is a solution having a higher concentration during the storage or transportation. Further, from the viewpoint of handling efficiency, the composition is preferably prepared in such a concentrated form.

Further, the solubility of each component in the composition varies depending upon the types or contents of other components. Therefore, even if the amount of each component is set within the above mentioned preferred range, it may happen that not all components will be uniformly dissolved or dispersed, or components once dissolved may again precipitate. In a case where any one of components in the composition has agglomerated or a component which should be dissolved, has precipitated, there will be no problem if it can be dispersed or dissolved again. Nevertheless, an additional operation will be required. Accordingly, the composition of the present invention is preferably in a uniformly dissolved or dispersed state not only at the time of its use but also in the state concentrated as described above. Specifically, in a polishing composition comprising colloidal silica as the abrasive, tetramethylammonium, hydroxide (TMAH) as the additive and a hydroxyethyl cellulose (HEC) having a molecular weight of 1.3 × 10⁶ as the water-soluble polymer, it is preferred that when the content of HEC is 0.25 wt%, the concentration of TMAH is from 0.001 to 0.3 wt%, whereby the composition is stable and free from a problem such as gelation.

The reason as to why the dopant striation scarcely forms with the polishing composition used in the present invention as compared with conventional polishing compositions containing an amine or ammonia, is not clearly understood. However, it may be that the polishing composition of the present invention provides a certain chemical action irrespective of the concentration of the dopant in the wafer. It is considered that the surface treating composition of the present invention will also provide the same action when it is applied to the wafer before polishing. Further, when it is applied to rinsing of the wafer after polishing, it is considered to provide a chemical action against shavings containing a dopant to enhance the cleaning effect.

Now, the present invention will be described in further detail with reference to Examples. However, it should be understood that the present invention is by no means restricted to such specific Examples.

### Stock removal polishing test

### Preparation of polishing compositions

Firstly, as an abrasive, colloidal silica (primary particle size: 35 nm, secondary particle size: 70 nm) was dispersed in water by means of a stirrer to obtain a slurry having an abrasive concentration of 2 wt%. Then, this slurry was divided, and the additives as identified in Table 1 were added to obtain test samples of Examples 1 to 13 and Comparative Examples 1 to 4, as polishing compositions.

### Polishing test

The polishing test was carried out under the following conditions.

### Polishing conditions

Polishing machine: One side polishing machine (surface plate diameter: 810 mm), four heads
Object to be polished: Three 127 mm (5-inch) silicon wafers were substantially equally bonded to a ceramic plate having a diameter of 300 mm (resistivity: 0.01 Ω·cm, crystal orientation P<100>).
Pressure: 350 g/cm²
Rotational speed of surface plate: 87 rpm
Polishing pad: BELLATRIX K0013 (manufactured by Kanebo Ltd.)
Amount of polishing composition supplied: 6,000 cc/min (used by recycling)
Polishing time: 20 minutes

After polishing, the wafers were sequentially washed and dried, and with respect to a total of twelve wafers, the changes in the thicknesses of the wafers due to polishing were obtained by using a micrometer, and an average of these values was used as the substitute value for the polishing removal rate.

Then, using a shadow graph (LX-230B, manufactured by Mizojiri Optical Co., Ltd.), light was irradiated on the wafer surface in a dark room, and the shadow projected on a screen was inspected to evaluate formation of dopant striation. The evaluation standards were as follows.
- ⓞ:: No dopant striation were observed.
- ○:: No substantial dopant striation were observed, and the striations were of a nonproblematic level.
- ×:: Dopant striation were observed at a problematic level.

Further, by using WYKO TOPO-3D objective lens (manufactured by WYKO Corporation, USA) (1.5 magnifications), the surface roughness: Ra of the wafers after polishing was measured.

The obtained results were as shown in Table 1.

**Table 1**

| | Additive | | Polishing removal rate (µm/20 minutes) | Surface state | Surface roughness Ra (nm) |
|---|---|---|---|---|---|
| | Type * | Amount (per liter) | | | |
| Ex. 1 | KOH | 0.1 g | 9.0 | ○ | 0.9 |
| Ex. 2 | KOH | 0.5 g | 10.7 | ⓞ | 0.9 |
| Ex. 3 | KOH | 2.0 g | 13.2 | ⓞ | 1.0 |
| Ex. 4 | KOH | 4.0 g | 13.7 | ⓞ | 1.1 |
| Ex. 5 | NaOH | 0.1 g | 10.6 | ○ | 0.9 |
| Ex. 6 | NaOH | 2.0 g | 12.7 | ⓞ | 1.0 |
| Ex. 7 | KC | 0.1 g | 10.0 | ○ | 0.9 |
| Ex. 8 | KC | 5.0 g | 10.4 | ○ | 0.9 |
| Ex. 9 | TMAH | 2.0 cc | 10.7 | ○ | 1.0 |
| Ex. 10 | TMAH | 7.5 cc | 11.9 | ○ | 0.9 |
| Ex. 11 | TMAH | 10 cc | 12.6 | ⓞ | 0.9 |
| Ex. 12 | TMAH | 15 cc | 13.7 | ⓞ | 0.9 |
| Ex. 13 | TMAH | 40 cc | 14.6 | ⓞ | 1.0 |
| Ex. 14 | H₂O₂ | 1.5 cc | 6.0 | ○ | 0.9 |
| Ex. 15 | H₂O₂ | 4.5 cc | 6.9 | ⓞ | 0.9 |
| Comp. Ex. 1 | - | - | 4.0 | × | 1.5 |
| Comp. Ex. 2 | MEA | 4.0 g | 10.2 | × | 1.9 |
| Comp. Ex. 3 | AEEA | 4.0 g | 11.3 | × | 2.0 |
| Comp. Ex. 4 | PIZ | 4.0 g | 13.5 | × | 1.9 |

| | | | | | |
|---|---|---|---|---|---|
| * KOH: potassium hydroxide NaOH: sodium hydroxide KC: potassium carbonate TMAH: tetramethylammonium hydroxide 3.6% solution H₂O₂: aqueous hydrogen peroxide solution 30% MEA: monoethanolamine AEEA: N-(β-aminoethyl)ethanolamine PIZ: piperazine hexahydrate | | | | | |

From the results shown in Table 1, it is evident that with the polishing compositions used in the present invention, the polishing removal rate is high in the polishing operation of low resistance silicon wafers, and it is possible to obtain a very smooth polished surface with little formation of dopant striation.

### Final polishing test

### Preparation of polishing compositions

Firstly, as an abrasive, colloidal silica (primary particle size: 35 nm, secondary particle size: 70 nm) was dispersed in water by means of a stirrer to obtain a slurry having an abrasive concentration as identified in Table 2. Then, this slurry was divided, and the additives as identified in Table 2 were added, and thereafter, a water-soluble polymer as identified in Table 2 was added to obtain test samples of Examples 16 to 30 and Comparative Examples 5 to 7 as polishing compositions.

### Polishing test

The polishing test was carried out under the following conditions.

### Polishing conditions

Polishing machine: One side polishing machine (surface plate diameter: 810 mm), four heads
Object to be polished: Polished wafer of Example 10 (surface roughness: Ra = 0.9 nm)
Pressure: 100 g/cm²
Rotational speed of surface plate: 60 rpm
Polishing pad: Surfin 000 (manufactured by FUJIMI INCORPORATED)
Amount of polishing composition supplied: 200 cc/min
Polishing time: 10 minutes

The state of the wafer surface after polishing was evaluated in the same manner as described above. The obtained results were as shown in Table 2.

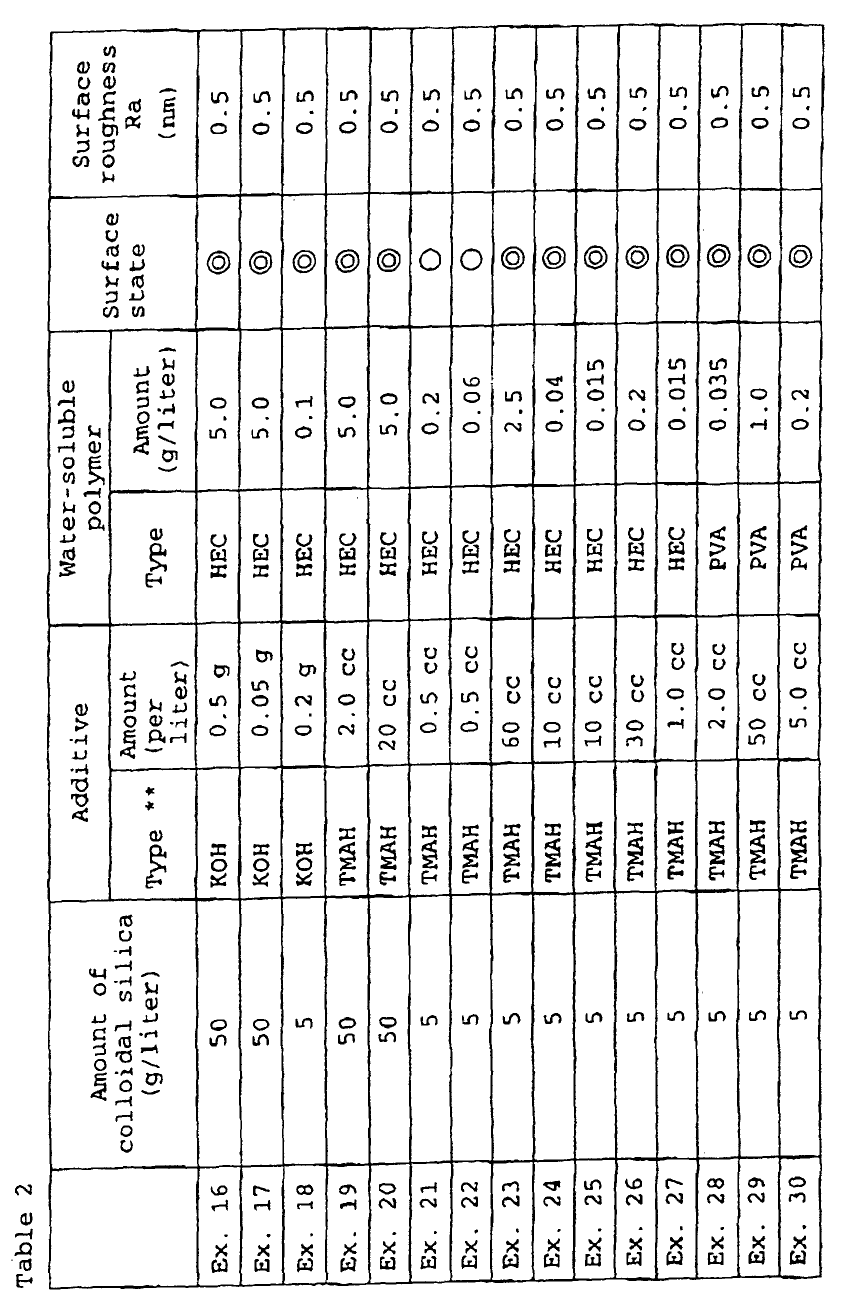

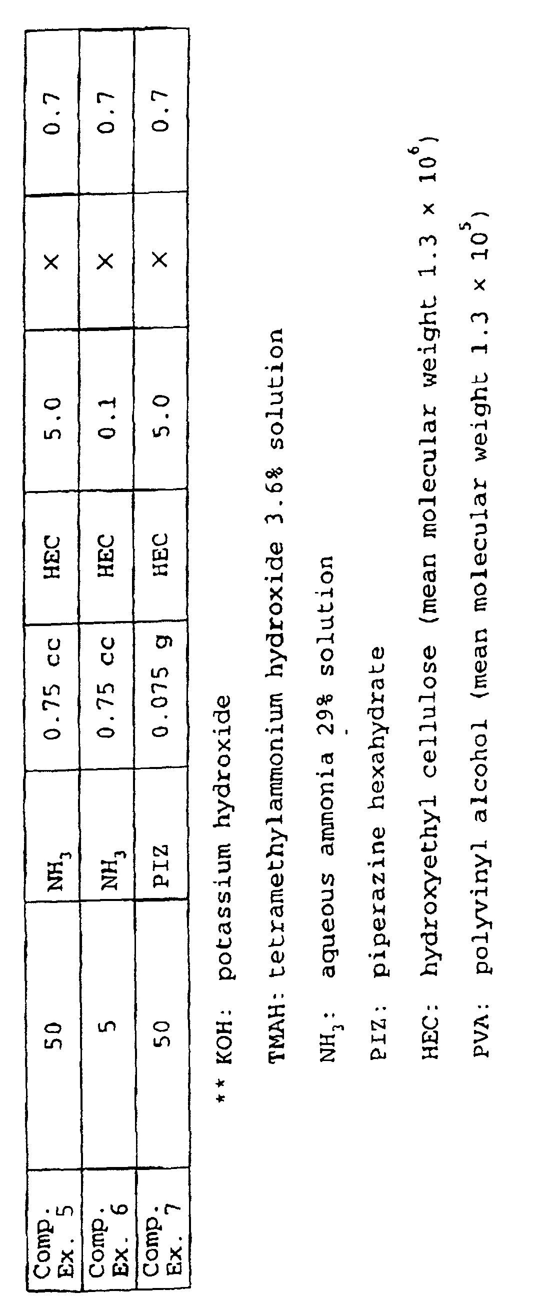

From the results shown in Table 2, it is evident that with the polishing compositions of the present invention, it is possible to obtain a very smooth polished surface with little formation of dopant striation in the polishing operation of low resistance silicon wafers.

As described in the foregoing, the polishing method of the present invention is capable of forming a very smooth polished surface free from waviness and presents a high polishing removal rate and little decrease in the polishing removal rate even when used by recycling, in the polishing operation of low resistance silicon wafers having a resistivity of at most 0.1 Ω·cm, and the surface treating method of the present invention is useful before and after the polishing operation of low resistance silicon wafers, to reduce formation of waviness in the polishing treatment, or to be highly effective in surface cleaning after the polishing.

## Claims

1. A method of polishing a silicon wafer having a resistivity of at most 0.1 Ω·cm, wherein there is used a polishing composition comprising water, an abrasive and, as an additive, at least one compound selected from an alkali metal hydroxide, an alkali metal carbonate, an alkali metal hydrogencarbonate, a quaternary ammonium salt, a peroxide and a peroxo acid compound.

2. The method according to claim 1, wherein the abrasive is silicon dioxide.

3. The method according to claim 2, wherein the silicon dioxide is at least one of colloidal silica, fumed silica and precipitated silica.

4. The method according to any one of claims 1 to 3, wherein the additive is at least one of potassium hydroxide, sodium hydroxide, potassium carbonate, sodium carbonate, potassium hydrogencarbonate, sodium hydrogencarbonate, tetramethylammonium hydroxide, tetraethylammonium hydroxide, tetrabutylammonium hydroxide, hydrogen peroxide, sodium peroxide, potassium peroxide, lithium peroxide, calcium peroxide, zirconium peroxide, peroxodisulfuric acid, ammonium peroxodisulfate, potassium peroxodisulfate, sodium peroxodisulfate peroxodiphosphoric acid, potassium peroxodiphosphate, potassium peroxocarbonate, sodium peroxocarbonate, sodium peroxoborate, magnesium peroxoborate and potassium peroxoborate.

5. The method according to any one of claims 1 to 4, wherein the content of the additive in the polishing composition is from 0.001 to 50 wt%, based on the total weight of the polishing composition.

6. The method according to any one of claims 1 to 5, wherein the content of the abrasive in the polishing composition is from 0.01 to 50 wt%, based on the total weight of the polishing composition.

7. The method according to any one of claims 1 to 6, wherein the polishing composition further contains a water-soluble polymer.

8. The method according to claim 7, wherein the content of the water-soluble polymer in the polishing composition is from 0.001 to 10 wt%, based on the total weight of the polishing composition.

9. A method of surface treating a silicon wafer having a resistivity of at most 0.1 Ω·cm, wherein there is used a surface treating composition comprising water and, as an additive, at least one compound selected from an alkali metal hydroxide, an alkali metal carbonate, an alkali metal hydrogencarbonate, a quaternary ammonium salt, a peroxide and a peroxo acid compound.

10. The method according to claim 9, wherein the additive is at least one of potassium hydroxide, sodium hydroxide, potassium carbonate, sodium carbonate, potassium hydrogencarbonate, sodium hydrogencarbonate, tetramethylammonium hydroxide, tetraethylammonium hydroxide, tetrabutylammonium hydroxide, hydrogen peroxide, sodium peroxide, potassium peroxide, lithium peroxide, calcium peroxide, zirconium peroxide, peroxodisulfuric acid, ammonium peroxodisulfate, potassium peroxodisulfate, sodium peroxodisulfate, peroxodiphosphoric acid, potassium peroxodiphosphate, potassium peroxocarbonate, sodium peroxocarbonate, sodium peroxoborate, magnesium peroxoborate and potassium peroxoborate.

11. The method according to claim 9 or 10, wherein the content of the additive in the surface treating composition is from 0.001 to 50 wt%, based on the total weight of the surface treating composition.

12. The method according to any one of claims 9 to 11, wherein the surface treating composition further contains a water-soluble polymer.

## Patentansprüche

1. Verfahren zum Polieren eines Siliciumwafers, der einen spezifischen Widerstand von höchstens 0,1 Ω·cm aufweist, bei dem eine Polierzusammensetzung verwendet wird, die Wasser, ein Schleifmittel und, als Additiv, zumindest eine aus Alkalimetallhydroxid, Alkalimetallcarbonat, Alkalimetallhydrogencarbonat, quaternärem Ammoniumsalz, Peroxid und einer Peroxosäureverbindung ausgewählte Verbindung umfasst.

2. Verfahren nach Anspruch 1, worin das Schleifmittel Siliciumdioxid ist.

3. Verfahren nach Anspruch 2, worin das Siliciumdioxid zumindest eines aus kolloidaler Kieselsäure, pyrogener Kieselsäure und Kieselhydrogel ist.

4. Verfahren nach einem der Ansprüche 1 bis 3, worin das Additiv zumindest eines aus Kaliumhydroxid, Natriumhydroxid, Kaliumcarbonat, Natriumcarbonat, Kaliumhydrogencarbonat, Natriumhydrogencarbonat, Tetramethylammoniumhydroxid, Tetraethylammoniumhydroxid, Tetrabutylammoniumhydroxid, Wasserstoffperoxid, Natriumperoxid, Kaliumperoxid, Lithiumperoxid, Calciumperoxid, Zirconiumperoxid, Peroxodischwefelsäure, Ammoniumperoxodisulfat, Kaliumperoxodisulfat, Natriumperoxodisulfat, Peroxodiphosphorsäure, Kaliumperoxodiphosphat, Kaliumperoxocarbonat, Natriumperoxocarbonat, Natriumperoxoborat, Magnesiumperoxoborat und Kaliumperoxoborat ist.

5. Verfahren nach einem der Ansprüche 1 bis 4, worin der Gehalt des Additivs in der Polierzusammensetzung, bezogen auf das Gesamtgewicht der Polierzusammensetzung, 0,001 bis 50 Gew.-% beträgt.

6. Verfahren nach einem der Ansprüche 1 bis 5, worin der Gehalt des Schleifmittels in der Polierzusammensetzung, bezogen auf das Gesamtgewicht der Polierzusammensetzung, 0,01 bis 50 Gew.-% beträgt.

7. Verfahren nach einem der Ansprüche 1 bis 6, worin die Polierzusammensetzung außerdem ein wasserlösliches Polymer enthält.

8. Verfahren nach Anspruch 7, worin der Gehalt des wasserlöslichen Polymers in der Polierzusammensetzung, bezogen auf das Gesamtgewicht der Polierzusammensetzung, 0,001 bis 10 Gew.-% beträgt.

9. Verfahren zur Oberflächenbehandlung eines Siliciumwafers mit einem spezifischen Widerstand von höchstens 0,1 Ω·cm, bei dem eine Oberflächenbehandlungszusammensetzung verwendet wird, die Wasser und, als Additiv, zumindest eine aus Alkalimetallhydroxid, Alkalimetallcarbonat, Alkalimetallhydrogencarbonat, quaternärem Ammoniumsalz, Peroxid und einer Peroxosäureverbindung ausgewählte Verbindung umfasst.

10. Verfahren nach Anspruch 9, worin das Additiv zumindest eines aus Kaliumhydroxid, Natriumhydroxid, Kaliumcarbonat, Natriumcarbonat, Kaliumhydrogencarbonat, Natriumhydrogencarbonat, Tetramethylammoniumhydroxid, Tetraethylammoniumhydroxid, Tetrabutylammoniumhydroxid, Wasserstoffperoxid, Natriumperoxid, Kaliumperoxid, Lithiumperoxid, Calciumperoxid, Zirconiumperoxid, Peroxodischwefelsäure, Ammoniumperoxodisulfat, Kaliumperoxodisulfat, Natriumperoxodisulfat, Peroxodiphosphorsäure, Kaliumperoxodiphosphat, Kaliumperoxocarbonat, Natriumperoxocarbonat, Natriumperoxoborat, Magnesiumperoxoborat und Kaliumperoxoborat ist.

11. Verfahren nach Anspruch 9 oder 10, worin der Gehalt des Additivs in der Oberflächenbehandlungszusammensetzung, bezogen auf das Gesamtgewicht der Oberflächenbehandlungszusammensetzung, 0,001 bis 50 Gew.-% beträgt.

12. Verfahren nach einem der Ansprüche 9 bis 11, worin die Oberflächenbehandlungszusammensetzung außerdem ein wasserlösliches Polymer enthält.

## Revendications

1. Méthode de polissage d'une pastille de silicium ayant une résistivité au plus de 0,1 Ω.cm, où on utilise une composition de polissage comprenant de l'eau, un abrasif et, en tant qu'additif, au moins un composé sélectionné parmi un hydroxyde d'un métal alcalin, un carbonate d'un métal alcalin, un hydrogénocarbonate d'un métal alcalin, un sel d'ammonium quaternaire, un peroxyde et un composé peroxo acide.

2. Méthode selon la revendication 1, où l'abrasif est du bioxyde de silicium.

3. Méthode de la revendication 2, où le bioxyde de silicium est au moins l'un de silice colloïdale, silice fumée et silice précipitée.

4. Méthode selon l'une quelconque des revendications 1 à 3, où l'additif est au moins l'un d'hydroxyde de potassium, oxyde de sodium, carbonate de potassium, carbonate de sodium, hydrogénocarbonate de potassium, hydrogénocarbonate de sodium, hydroxyde de tétraméthylammonium, hydroxyde de tétraéthylammonium, hydroxyde de tétrabutylammonium, peroxyde d'hydrogène, peroxyde de sodium, peroxyde de potassium, peroxyde de lithium, peroxyde de calcium, peroxyde de zirconium, acide peroxodisulfurique, peroxodisulfate d'ammonium, peroxodisulfate de potassium, peroxodisulfate de sodium, acide peroxodiphosphorique, peroxodiphosphate de potassium, peroxocarbonate de potassium, peroxocarbonate de sodium, peroxoborate de sodium, peroxoborate de magnésium et peroxoborate de potassium.

5. Méthode selon l'une quelconque des revendications 1 à 4, où le contenu de l'additif dans la composition de polissage est de 0,001 à 50% pds, en se basant sur le poids total de la composition de polissage.

6. Méthode selon l'une quelconque des revendications 1 à 5, où le contenu de l'abrasif dans la composition de polissage est de 0,01 à 50% pds, en se basant sur le poids total de la composition de polissage.

7. Méthode selon l'une quelconque des revendications 1 à 6, où la composition de polissage contient de plus un polymère soluble dans l'eau.

8. Méthode selon la revendication 7, où le contenu du polymère soluble dans l'eau dans la composition de polissage est de 0,001 à 10% pds, en se basant sur le poids total de la composition de polissage.

9. Méthode de traitement de surface d'une pastille de silicium ayant une résistivité au plus de 0,1 Ω.cm, où on utilise une composition de traitement de surface comprenant de l'eau et, en tant qu'additif, au moins un composé sélectionné parmi un hydroxyde d'un métal alcalin, un carbonate d'un métal alcalin, un hydrogénocarbonate d'un métal alcalin, un sel d'ammonium quaternaire, un peroxyde et un composé de peroxo acide.

10. Méthode selon la revendication 9, où l'additif est au moins l'un d'hydroxyde de potassium, hydroxyde de sodium, carbonate de potassium, carbonate de sodium, hydrogénocarbonate de potassium, hydrogénocarbonate de sodium, hydroxyde de tétraméthylammonium, hydroxyde de tétraéthylammonium, hydroxyde de tétrabutylammonium, peroxyde d'hydrogène, peroxyde de sodium, peroxyde de potassium, peroxyde de lithium, peroxyde de calcium, peroxyde de zirconium, acide peroxodisulfurique, peroxodisulfate d'ammonium, peroxodisulfate de potassium, peroxodisulfate de sodium, acide peroxodiphosphorique, peroxodiphosphate de potassium, peroxocarbonate de potassium, peroxocarbonate de sodium, peroxoborate de sodium, peroxoborate de magnésium et peroxoborate de potassium.

11. Méthode selon la revendication 9 ou 10, où le contenu de l'additif dans la composition de traitement de surface est de 0,001 à 50% pds, en se basant sur le poids total de la composition de traitement de surface.

12. Méthode selon l'une quelconque des revendications 9 à 11, où la composition de traitement de surface contient de plus un polymère soluble dans l'eau.
